# DEMANDE DE BREVET EUROPEEN

(11) **EP 3 886 159 A1**
(43) Date de publication de la demande: **29.09.2021**
(21) Numéro de dépôt: 21164134.5
(22) Date de dépôt: 23.03.2021
(51) Int. Cl.: H01L 23/498, H01L 23/538

(54) **PUCE D'INTERCONNEXION**

(30) Priorité: 26.03.2020 FR 2002970
(71) Demandeur: Commissariat à l'Energie Atomique et aux Energies Alternatives, 75015 Paris (FR)
(72) Inventeur: CHARBONNIER, Jean, 38054 GRENOBLE CEDEX 09 (FR); ASSOUS, Myriam, 38054 GRENOBLE CEDEX 09 (FR); TISSIER, Pierre, 42720 POUILLY SOUS CHARLIEU (FR)
(74) Mandataire: Cabinet Beaumont

(57) **Abrégé**

La présente description concerne une puce (102) d'interconnexion formée dans et sur un substrat semiconducteur, destinée à être interposée entre un premier dispositif (104) électronique et un deuxième dispositif (106) électronique, la puce comportant une première face (102B), destinée à être placée en regard du premier dispositif électronique, et une deuxième face (102T), opposée à la première face et destinée à être placée en regard du deuxième dispositif, la puce comportant en outre, du côté de la première face :
au moins un plot (108) métallique assurant une fonction de connexion électrique avec le premier dispositif électronique ; et
au moins une région (120) métallique dépourvue de fonction de connexion électrique,
dans laquelle ledit au moins un plot et ladite au moins une région font partie d'un même niveau métallique de routage.

## Description

### Domaine technique

La présente description concerne de façon générale les dispositifs électroniques et, plus particulièrement, les puces semiconductrices d'interconnexion destinées à être interposées entre des dispositifs électroniques superposés.

### Technique antérieure

On utilise généralement des puces semiconductrices d'interconnexion, également appelées interposeurs, pour des applications dites d'intégration 3D, dans lesquelles on souhaite interconnecter des dispositifs électroniques en trois dimensions. De telles puces d'interconnexion sont, par exemple, intercalées entre une puce de circuit intégré et une carte de circuit imprimé pour former un réseau de connexions électriques intermédiaires entre la puce et la carte.

Afin de répondre à des contraintes d'intégration, telles que celles du domaine du calcul haute performance (High-Performance Computing - HPC), on cherche désormais à fabriquer des puces d'interconnexion présentant des surfaces de plus en plus importantes, pouvant typiquement atteindre plusieurs centimètres carrés. L'épaisseur de ces puces d'interconnexion demeure toutefois généralement limitée, typiquement à une centaine de microns, principalement en raison des procédés mis en œuvre pour réaliser des vias conducteurs entre des faces supérieure et inférieure de ces puces.

Les puces d'interconnexion de ce type, qui présentent des dimensions latérales nettement supérieures à leur épaisseur, sont fréquemment sujettes à des phénomènes de déformation qui tendent à perturber, voire à empêcher, leur intégration.

### Résumé de l'invention

Il existe un besoin d'améliorer les puces d'interconnexion actuelles.

Un mode de réalisation pallie tout ou partie des inconvénients des puces d'interconnexion connues.

Un mode de réalisation prévoit une puce d'interconnexion formée dans et sur un substrat semiconducteur, destinée à être interposée entre un premier dispositif électronique et un deuxième dispositif électronique, la puce comportant une première face, destinée à être placée en regard du premier dispositif électronique, et une deuxième face, opposée à la première face et destinée à être placée en regard du deuxième dispositif, la puce comportant en outre, du côté de la première face :
au moins un plot métallique assurant une fonction de connexion électrique avec le premier dispositif électronique ; et
au moins une région métallique dépourvue de fonction de connexion électrique,
dans laquelle ledit au moins un plot et ladite au moins une région font partie d'un même niveau métallique de routage et dans laquelle ledit au moins un plot est relié à la deuxième face de la puce d'interconnexion par l'intermédiaire d'un via conducteur, traversant le substrat semiconducteur.

Selon un mode de réalisation, ladite au moins une région métallique est entièrement entourée de matériau isolant.

Selon un mode de réalisation, la puce comporte, du côté de la deuxième face, un empilement de couches métalliques et isolantes alternées, formant un réseau d'interconnexion.

Selon un mode de réalisation, la puce comporte une pluralité de régions métalliques réparties de façon régulière dans au moins une région de la première face ne comportant aucun plot métallique.

Selon un mode de réalisation, les régions métalliques forment, dans ladite au moins une région de la première face ne comportant aucun plot métallique, un réseau dont le pas est supérieur à environ 10 µm, de préférence compris entre 10 µm et 500 µm, plus préférentiellement compris entre 50 µm et 200 µm.

Selon un mode de réalisation, les régions métalliques occupent entre 10 % et 50 %, de préférence entre 30 % et 50 %, de la surface de ladite au moins une région de la première face ne comportant aucun plot métallique.

Selon un mode de réalisation, chaque région métallique présente, vue de côté, une épaisseur comprise entre 0,5 µm et 10 µm, de préférence comprise entre 3 µm et 5 µm.

Selon un mode de réalisation, chaque région métallique présente une forme de plot présentant de préférence, vu de face, une dimension maximale comprise entre 20 µm et 100 µm, de préférence égale à environ 50 µm.

Selon un mode de réalisation, chaque région métallique présente une forme de bande présentant de préférence, vue de face, une largeur comprise entre 20 µm et 100 µm, de préférence égale à environ 50 µm.

Selon un mode de réalisation, le substrat semiconducteur présente une épaisseur comprise entre 30 µm et 300 µm, de préférence entre 50 µm et 150 µm.

Selon un mode de réalisation, les première et deuxième faces présentent chacune une surface comprise entre 1 cm² et 15 cm².

Selon un mode de réalisation, la puce comprend en outre des composants électroniques et/ou photoniques réalisés dans une couche semiconductrice du substrat.

Un mode de réalisation prévoit un système comprenant :
un premier dispositif électronique ;
une puce d'interconnexion telle que décrite, la puce étant connectée, par sa première face, à une face supérieure du premier dispositif électronique ; et
un deuxième dispositif électronique, dont une face inférieure est connectée à la face supérieure de la puce d'interconnexion.

Selon un mode de réalisation :
le premier dispositif électronique est une carte de circuit imprimé ; et
le deuxième dispositif électronique est une puce de circuit intégré.

Un mode de réalisation prévoit un procédé de fabrication d'une puce d'interconnexion telle que décrite, dans lequel ledit au moins un plot métallique et ladite au moins une région métallique sont formés simultanément au cours d'une même étape.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 est une vue en perspective, schématique et partielle, d'un mode de réalisation d'un système comprenant une puce électronique d'interconnexion ;
la figure 2 est une vue de dessus, schématique et partielle, du système de la figure 1 ;
la figure 3 est une vue de dessous, schématique et partielle, du système de la figure 1 ;
la figure 4 est une vue en coupe, schématique et partielle, du système de la figure 1 ;
la figure 5 est une vue en coupe, schématique et partielle, illustrant une étape d'un mode de mise en œuvre d'un procédé de fabrication du système de la figure 1 ;
la figure 6 est une vue en coupe, schématique et partielle, illustrant une autre étape du mode de mise en œuvre du procédé de fabrication du système de la figure 1 ;
la figure 7 est une vue en coupe, schématique et partielle, illustrant encore une autre étape du mode de mise en œuvre du procédé de fabrication du système de la figure 1 ;
la figure 8 est une vue en coupe, schématique et partielle, illustrant encore une autre étape du mode de mise en œuvre du procédé de fabrication du système de la figure 1 ;
la figure 9 est une vue en coupe, schématique et partielle, illustrant encore une autre étape du mode de mise en œuvre du procédé de fabrication du système de la figure 1 ;
la figure 10 est une vue en coupe, schématique et partielle, illustrant encore une autre étape du mode de mise en œuvre du procédé de fabrication du système de la figure 1 ;
la figure 11 est une vue en coupe, schématique et partielle, illustrant encore une autre étape du mode de mise en œuvre du procédé de fabrication du système de la figure 1 ;
la figure 12 est une vue en coupe, schématique et partielle, illustrant encore une autre étape du mode de mise en œuvre du procédé de fabrication du système de la figure 1 ;
la figure 13 est une vue en coupe, schématique et partielle, illustrant encore une autre étape du mode de mise en œuvre du procédé de fabrication du système de la figure 1 ;
la figure 14 est une vue en coupe, schématique et partielle, illustrant encore une autre étape du mode de mise en œuvre du procédé de fabrication du système de la figure 1 ; et
la figure 15 est une vue en coupe, schématique et partielle, illustrant encore une autre étape du mode de mise en œuvre du procédé de fabrication du système de la figure 1.

### Description des modes de réalisation

De mêmes éléments ont été désignés par de mêmes références dans les différentes figures. En particulier, les éléments structurels et/ou fonctionnels communs aux différents modes de réalisation et modes de mise en œuvre peuvent présenter les mêmes références et peuvent disposer de propriétés structurelles, dimensionnelles et matérielles identiques.

Par souci de clarté, seuls les étapes et éléments utiles à la compréhension des modes de réalisation et modes de mise en œuvre décrits ont été représentés et sont détaillés. En particulier, les dispositifs et les applications visés par les puces d'interconnexion décrites ne sont pas détaillés, les modes de réalisation et modes de mise en œuvre décrits étant compatibles avec les dispositifs et les applications usuels comportant des puces d'interconnexion.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence, sauf précision contraire, à l'orientation des figures.

Sauf précision contraire, les expressions "environ", "approximativement", "sensiblement", et "de l'ordre de" signifient à 10 % près, de préférence à 5 % près.

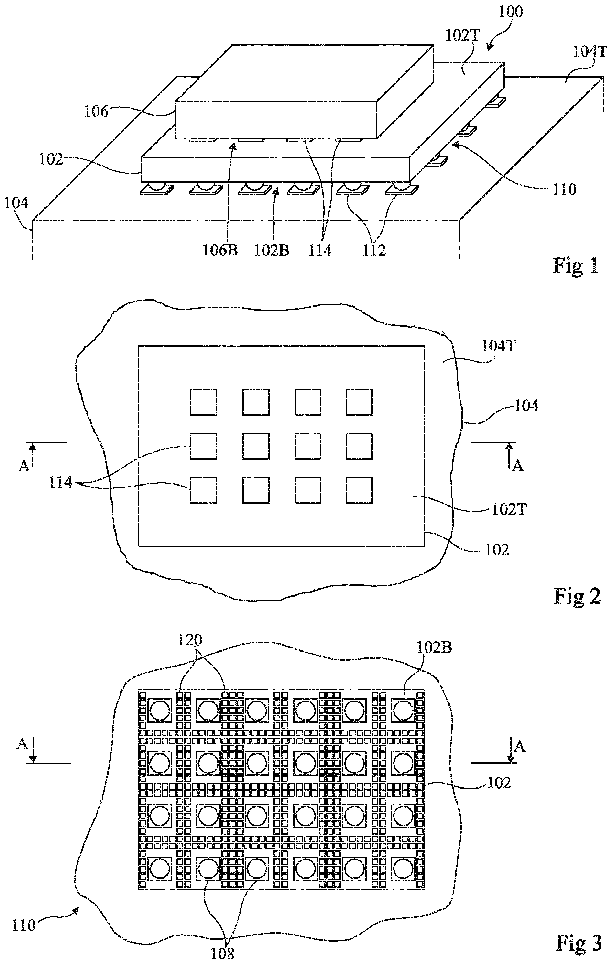

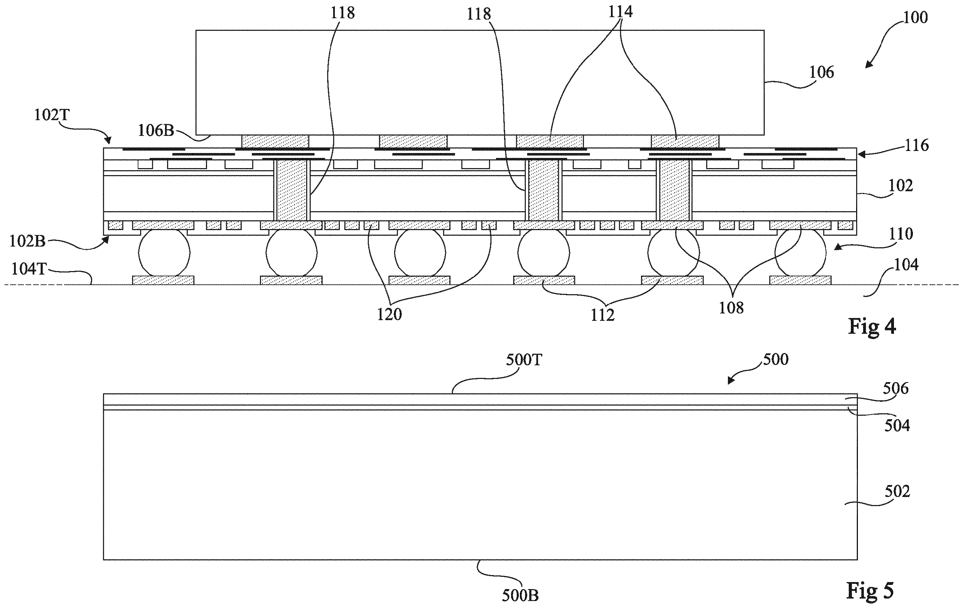

Les figures 1 à 4 sont des vues respectivement en perspective, de dessus, de dessous et en coupe, schématiques et partielles, d'un exemple d'un mode de réalisation d'un système 100 comprenant une puce électronique 102 d'interconnexion. La figure 4 est, plus précisément, une vue en coupe selon le plan AA (figures 2 et 3) du système 100.

La puce électronique 102 d'interconnexion, également appelée interposeur (« interposer » en anglais) dans la présente description, est interposée ou intercalée entre deux dispositifs électroniques 104 et 106. Le dispositif électronique 104 est, par exemple, une carte de circuit imprimé (Printed Circuit Board - PCB), dont seule une partie est visible en figures 1 à 4. Le dispositif électronique 106 est, par exemple, une puce électronique de circuit intégré (Integrated Circuit - IC).

En variante, le dispositif électronique 104 du système 100 est une autre puce électronique de circuit intégré, dont seule une partie est visible en figures 1 à 4.

Selon un mode de réalisation, la puce 102 est réalisée dans et sur un substrat semiconducteur, par exemple un substrat en silicium.

Dans l'orientation des figures 1 et 4, la carte 104 de circuit imprimé et la puce 106 de circuit intégré sont respectivement situées en dessous et au-dessus de la puce 102 d'interconnexion. Plus précisément, toujours dans cette orientation, une face inférieure 102B de la puce 102 est placée en regard d'une face supérieure 104T de la carte 104, tandis qu'une face supérieure 102T de la puce 102, opposée à la face 102B, est placée en regard d'une face inférieure 106B de la puce 106. Dans le système 100, les faces 104T, 102B, 102T et 106B sont sensiblement parallèles entre elles.

Selon un mode de réalisation, des plots (pad) 108 de connexion, situés du côté de la face inférieure 102B de la puce 102, sont connectés, de préférence par l'intermédiaire d'une matrice 110 de billes de soudure (Ball Grid Array - BGA), à d'autres plots 112 de connexion, situés du côté de la face supérieure 104T de la carte 104. De façon plus générale, la puce 102 est connectée électriquement, du côté de sa face inférieure 102B, à la carte 104.

Dans l'exemple représenté, les plots 108 de connexion présentent, vus de dessous (figure 3), une forme carrée. Cela n'est toutefois pas limitatif, les plots 108 pouvant en pratique présenter, vus de dessous, une forme quelconque, par exemple circulaire ou rectangulaire.

Selon ce mode de réalisation, encore d'autres plots 114 de connexion, situés du côté de la face supérieure 102T de la puce 102, sont connectés à encore d'autres plots de connexion (non représentés), situés du côté de la face inférieure 106B de la puce 106. De façon plus générale, la puce 102 est connectée électriquement, du côté de sa face supérieure 102T, à la puce 106.

Dans l'exemple représenté, les plots 114 de connexion présentent, vus de dessus (figure 2), une forme carrée. Cela n'est toutefois pas limitatif, les plots 114 pouvant en pratique présenter, vus de dessus, une forme quelconque, par exemple circulaire ou rectangulaire. À titre d'exemple, chaque plot 114 présente, en vue de dessus, une dimension maximale comprise entre 10 µm et 200 µm, de préférence entre 10 µm et 50 µm, par exemple égale à environ 20 µm.

Comme illustré en figure 4, dans cet exemple, la puce 102 comporte, du côté de sa face supérieure 102T, un empilement 116 comprenant des niveaux de métallisation séparés les uns des autres par des couches diélectriques. Chaque niveau de métallisation de l'empilement 116 comporte typiquement plusieurs portions disjointes, isolées électriquement les unes des autres, d'une même couche métallique.

En figure 4, trois rangées de traits horizontaux discontinus symbolisent trois niveaux de métallisation superposés. Toutefois, en pratique, l'empilement 116 peut comporter un nombre quelconque de niveaux de métallisation. L'empilement 116 comporte, par exemple, deux à huit, de préférence deux à quatre, niveaux de métallisation.

Bien qu'ils ne soient pas représentés en figure 4, des vias conducteurs peuvent être réalisés dans l'empilement 116. Ces vias permettent notamment d'interconnecter plusieurs portions de couches métalliques faisant partie de niveaux de métallisation distincts.

Comme illustré en figure 4, les plots 114 de connexion de la face supérieure 102T de la puce 102 contactent des portions de couche métallique appartenant à un même niveau de métallisation de l'empilement 116 (le niveau de métallisation supérieur, dans l'orientation de la figure 4). D'autres portions de couche métallique, faisant partie d'un même autre niveau de métallisation de l'empilement 116 (le niveau de métallisation inférieur, dans l'orientation de la figure 4), contactent des vias 118 conducteurs. Chaque via 118 traverse de part en part, sur toute son épaisseur, le substrat semiconducteur dans et sur lequel est formée la puce 102. En figure 4, chaque via conducteur 118 contacte, en outre, l'un des plots 108 de connexion de la face inférieure 102B de la puce 102.

L'empilement 116 et les vias 118 participent notamment à la réalisation d'une fonction de routage des connexions électriques à travers la puce 102, plus particulièrement entre les plots 114 de sa face supérieure 102T et les plots 108 de sa face inférieure 102B. La puce 102 permet ainsi de former un réseau de connexions électriques intermédiaires entre la puce 106 de circuit intégré et la carte 104 de circuit imprimé. En particulier, la puce 102 peut être utilisée pour relier ou connecter plusieurs plots 114 de connexion de la puce 106 entre eux, et/ou pour relier ou connecter un ou plusieurs plots 114 de connexion de la puce 106 à un ou plusieurs plots 112 de connexion de la carte 104.

La puce 102 d'interconnexion peut présenter une densité de contacts 108 en face inférieure 102B plus faible que la densité de contacts 114 en face supérieure 102T. Cela permet notamment de réduire le nombre de plots 112 de connexion à prévoir du côté de la face supérieure 104T de la carte 104.

La puce 102 d'interconnexion peut être prévue pour assurer uniquement des fonctions de routage entre sa face supérieure 102T et sa face inférieure 102B. La puce 102 est alors qualifiée de puce d'interconnexion passive, ou d'interposeur passif.

En variante, la puce 102 comporte non seulement des éléments conducteurs de routage, mais également un ou plusieurs éléments actifs, par exemple des amplificateurs, des multiplexeurs, des alimentations, etc. La puce 102 est alors qualifiée de puce d'interconnexion active, ou d'interposeur actif.

Sur sa face inférieure 102B, la puce 102 comporte, outre les plots 108 de connexion, des régions 120 métalliques. Dans l'exemple illustré en figure 3, chaque région métallique 120 présente une forme de plot. À la différence des plots 108, qui assurent une fonction de connexion électrique avec la carte 104, les régions 120 sont dépourvues de toute fonction de connexion électrique. En d'autres termes, chaque région 120 n'est reliée, ou connectée, à aucun autre élément de connexion électrique. Aucune région 120 n'est, en particulier, électriquement en contact avec l'un des vias traversants 118 de la puce 102. À titre d'exemple, chaque région 120 est entièrement entourée, sur toutes ses faces, de matériau électriquement isolant.

À titre de variante, les régions 120 métalliques sont des bandes conductrices parallèles et électriquement isolées les unes des autres. Dans cette variante, les bandes peuvent par exemple être sensiblement orthogonales à l'un des côtés de la puce 102 et s'étendre sur au moins 50 %, de préférence au moins 75 %, de la distance séparant ce côté d'un côté opposé de la puce 102. Alternativement, les bandes sont par exemple orientées de façon à former un angle non droit, par exemple égal à environ 45°, par rapport à l'un des côtés de la puce 102. Dans ce cas, les bandes s'étendent par exemple sur au moins 50 %, de préférence au moins 75 %, de la distance séparant ce côté d'un côté adjacent de la puce 102. Les bandes conductrices sont par exemple régulièrement espacées et présentent une largeur identique, aux dispersions de fabrication près.

Selon un mode de réalisation, les régions métalliques 120 sont, comme illustré en figure 3, réparties de façon régulière dans une ou plusieurs régions de la face inférieure 102B de la puce 102 ne comportant aucun plot 108 de connexion. Dans ces régions dépourvues de plots 108 de connexion, les régions métalliques 120 forment, de préférence, un réseau dont le pas est supérieur à environ 10 µm, de préférence compris entre 10 µm et 500 µm, plus préférentiellement compris entre 50 µm et 200 µm. Dans la présente description, on désigne par pas du réseau la distance centre à centre entre deux plots voisins ou la distance entre deux lignes médianes de deux bandes voisines.

Vues de dessous (figure 3), les régions 120 occupent entre 10 % et 50 %, de préférence entre 30 % et 50 %, de la surface totale des zones non recouvertes par les plots 108 de connexion de la puce 102. Selon un mode de réalisation, chaque région 120 présente, vue de dessous, une dimension maximale, dans le cas d'un plot, ou une largeur, dans le cas d'une bande, comprise entre 20 µm et 100 µm, de préférence égale à environ 50 µm.

Dans l'exemple représenté, les plots formant les régions 120 présentent, vus de dessous (figure 3), une forme carrée. Cela n'est toutefois pas limitatif, les plots formant les régions 120 pouvant en pratique présenter, vus de dessous, une forme quelconque, par exemple circulaire ou rectangulaire. Les plots formant les régions 120 présentent tous, de préférence, la même forme et les mêmes dimensions (aux dispersions de fabrication près).

Les régions 120 métalliques présentent, de préférence, une épaisseur égale à celle des plots 108 de connexion (aux dispersions de fabrication près). À titre d'exemple, chaque région 120 présente, vue de côté (figure 4), une épaisseur comprise entre 0,5 µm et 10 µm, par exemple inférieure à 7 µm, de préférence comprise entre 3 µm et 5 µm. Les plots 108 de connexion et les régions 120 dépourvues de fonction de connexion sont, de préférence, réalisés dans un même niveau de métallisation.

La puce 102 d'interconnexion présente par exemple, vue de dessus (figure 2), une surface comprise entre 1 cm² et 15 cm². En outre, la puce 102 présente par exemple, vue de côté (figure 4), une épaisseur comprise entre 30 µm et 300 µm, de préférence entre 50 µm et 150 µm.

Les plots 108, 112 et 114 de connexion sont en matériau conducteur électriquement, par exemple en métal ou en alliage métallique, de préférence en cuivre. Les régions 120 sont, de préférence, constituées du même matériau que les plots 108.

Selon un mode de mise en œuvre, les plots 108 et les régions 120 présentent chacun une structure monocouche. En variante, les plots 108 et les régions 120 présentent chacun une structure multicouche, constituée d'un empilement de plusieurs couches métalliques.

Les billes de soudure de la matrice 110 sont en un matériau conducteur électriquement, de préférence en un alliage métallique à base d'étain, par exemple un alliage d'étain et d'argent ou un alliage d'étain, d'argent et de cuivre. De manière générale, ces billes sont, de préférence, en un matériau dont la température de fusion est inférieure à celle des plots 108 et 112. Cela permet ainsi de lier la puce 102 à la carte 104 sans endommager les plots 108 et 112 situés de part et d'autre de la matrice 110 de billes de soudure.

Les procédés de report d'une puce d'interconnexion sur une carte de circuit imprimé comprennent souvent une étape de chauffage, destinée à faire fondre des billes de soudure pour connecter des plots de la puce à des plots de la carte. Durant cette étape, on chauffe généralement la puce jusqu'à atteindre ou dépasser la température de refusion des billes de soudure, typiquement de l'ordre de 275 °C. On observe alors classiquement une déformation de la puce. Cela perturbe ou empêche la mise en œuvre du procédé de report.

La déformation observée résulte notamment d'une dilatation différente des faces supérieure et inférieure de la puce. Les inventeurs ont notamment constaté qu'une puce d'interconnexion comportant, sur l'une de ses faces, un empilement analogue à l'empilement 116 mais ne comportant pas les régions 120 sur sa face opposée, subit des déformations relativement importantes.

Un avantage de la puce 102 d'interconnexion tient au fait qu'elle ne subit pas, ou subit peu, de déformations lors de l'étape de chauffage. En effet, la présence des régions 120 contribue à compenser des contraintes mécaniques susceptibles de s'exercer du côté de la face supérieure 102T sous l'effet de la dilatation des couches de l'empilement 116.

En ajustant la densité et/ou le pas du réseau formé par les régions 120 du côté de la face 102B, on peut ainsi compenser ou équilibrer les contraintes mécaniques s'exerçant du côté de la face 102T opposée de la puce 102. Les contraintes mécaniques s'exerçant du côté de la face 102T peuvent en outre être compensées en ajustant l'épaisseur des régions 120.

À titre d'exemple, on considère arbitrairement des puces 102 d'une épaisseur de 100 µm que l'on soumet chacune à une rampe de température allant de 30 °C à 300 °C. Pour différentes densités et épaisseurs de régions 120, on évalue par exemple une variation totale de flèche de la puce 102 et une vitesse ou ratio de variation de flèche de la puce 102.

Par flèche de la puce 102, on entend une mesure de déformation de la puce 102 effectuée, par exemple, entre les coins et le centre de la puce 102. Dans un cas, par exemple, où la flèche de la puce 102 varie de façon monotone pendant la rampe de température, la variation totale de flèche de la puce 102 correspond à la différence, en valeur absolue, entre les flèches de la puce 102 mesurées respectivement au départ et à la fin de la rampe (à 30 °C et à 300 °C dans cet exemple) . La vitesse ou ratio de variation de la flèche de la puce 102 correspond à un taux de variation, par unité de température, de la flèche de la puce 102.

Dans le cas où les régions 120 sont en forme de plots, on observe ainsi, par exemple :
une variation totale de flèche égale à 224 µm et un ratio de variation de flèche égal à environ 0,770 µm/°C, pour une puce 102 dont les régions 120 présentent une densité égale à 0,05 % et une épaisseur égale à 2 µm ;
une variation totale de flèche égale à 195 µm et un ratio de variation de flèche égal à environ 0,698 µm/°C, pour une puce 102 dont les régions 120 présentent une densité égale à 18 % et une épaisseur égale à 2,5 µm ;
une variation totale de flèche égale à 189 µm et un ratio de variation de flèche égal à environ 0,668 µm/°C, pour une puce 102 dont les régions 120 présentent une densité égale à 36 % et une épaisseur égale à 2,5 µm ; et
une variation totale de flèche égale à 154 µm et un ratio de variation de flèche égal à environ 0,544 µm/°C, pour une puce 102 dont les régions 120 présentent une densité égale à 36 % et une épaisseur égale à 3,6 µm.

Les inventeurs ont constaté que, pour une même densité de régions 120 métalliques, la flèche est plus importante si les régions 120 sont en forme de bandes plutôt qu'en forme de plots. Une densité moindre de régions 120 métalliques en forme de bandes permet ainsi avantageusement d'obtenir une valeur de flèche sensiblement égale à celle observée lorsque les régions 120 sont en forme de plots. Alternativement, une flèche plus importante peut être obtenue en mettant en œuvre des régions 120 en forme de bandes plutôt qu'en forme de plots sans qu'il ne soit nécessaire d'augmenter la densité des régions 120.

On a décrit ci-dessus en relation avec les figures 1 à 4 un mode de réalisation d'un système 100 dans lequel une seule puce 106 de circuit intégré est située au-dessus de la puce d'interconnexion 102. Cela n'est toutefois pas limitatif. En pratique, plusieurs puces de circuit intégré peuvent être connectées à la face supérieure de la puce d'interconnexion 102. Dans ce cas, la puce 102 peut en particulier avoir pour fonction de relier ou d'interconnecter des plots de connexion appartenant à des puces distinctes.

On a en outre décrit ci-dessus en relation avec les figures 1 à 4 un mode de réalisation d'un système 100 dans lequel la face inférieure 102B de la puce 102 comporte des plots 108 et des régions 120, et dans lequel la face supérieure 102T de la puce 102 comporte des plots 114. À titre de variante, la puce 102 peut de surcroît comporter, du côté de sa face supérieure 102T, une ou plusieurs pistes conductrices permettant d'interconnecter et/ou de déporter des plots 114 de connexion. De façon analogue, la puce 102 peut en outre comporter, du côté de sa face inférieure 102B, une ou plusieurs pistes conductrices permettant d'interconnecter et/ou de déporter des plots 108 de connexion.

Les figures 5 à 15 ci-dessous illustrent des étapes successives d'un exemple d'un mode de mise en œuvre d'un procédé de fabrication du système 100 de la figure 1.

La figure 5 est une vue en coupe, schématique et partielle, illustrant une étape du mode de mise en œuvre du procédé de fabrication du système 100 de la figure 1.

Au cours de cette étape, on commence par prévoir un substrat 500. Le substrat 500 est, par exemple, obtenu à partir d'une plaquette (wafer) ou d'un morceau de plaquette en un matériau semiconducteur. Dans l'orientation de la figure 5, on note respectivement 500B et 500T les faces inférieure et supérieure du substrat 500.

Dans l'exemple représenté, le substrat 500 comporte, du côté de sa face supérieure 500T, une structure du type silicium sur isolant (Silicon On Insulator - SOI). Le substrat 500 comporte, plus précisément, une couche 502 support revêtue d'une autre couche 504. La couche 504 s'étend de façon continue et sur toute la surface supérieure de la couche support 502. La couche 504 est revêtue d'encore une autre couche 506, qui s'étend de façon continue et sur toute la surface supérieure de la couche 504.

La couche 502 est en un matériau semiconducteur, par exemple du silicium. La couche 504 est en un matériau isolant électriquement, par exemple en oxyde de silicium. La couche 506 est en un matériau semiconducteur, par exemple en silicium.

Le substrat 500 présente, à ce stade, une épaisseur comprise entre 500 µm et 1 mm, par exemple égale à environ 725 µm pour une plaquette de 200 mm de diamètre ou à environ 775 µm pour une plaquette de 300 mm de diamètre. À titre d'exemple, la couche 504 présente une épaisseur comprise entre 50 nm et 2 µm, par exemple égale à 1,5 µm.

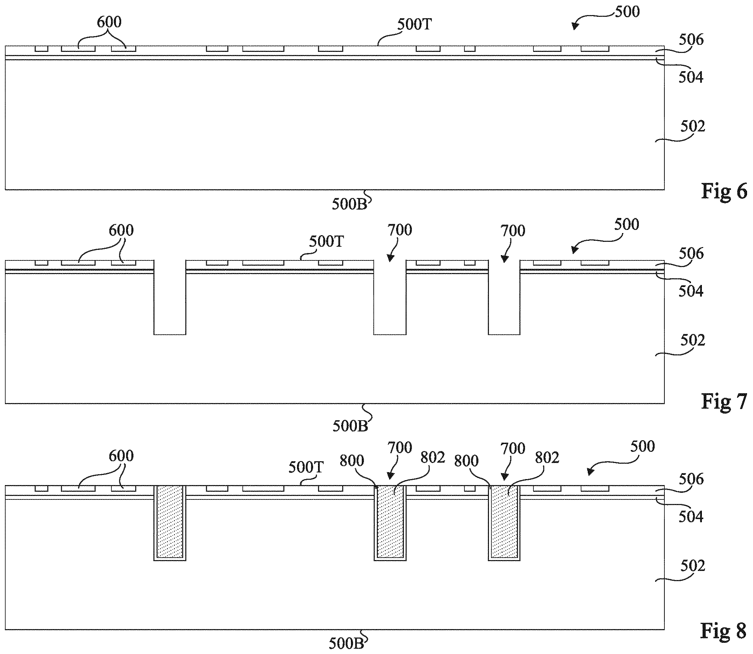

La figure 6 est une vue en coupe, schématique et partielle, illustrant une autre étape du mode de mise en œuvre du procédé de fabrication du système 100 de la figure 1, réalisée à partir de la structure telle que décrite en relation avec la figure 5.

La figure 6 illustre, plus particulièrement, un cas où l'on prévoit de fabriquer une puce d'interconnexion active. Des composants 600 sont réalisés dans la couche 506 du substrat 500. À titre d'exemple les composants 600 peuvent être des composants électroniques, par exemple des transistors, des diodes, etc. et/ou des composants photoniques, par exemple des photodiodes, des amplificateurs ou modulateurs optiques, des guides d'ondes, etc. On peut alors obtenir, par exemple, une puce active en technologie semiconducteur à oxyde de métal complémentaire (Complementary Metal-Oxide Semiconductor - CMOS, en anglais), une puce active photonique, etc. faisant également office de puce d'interconnexion.

En variante, si l'on souhaite fabriquer une puce d'interconnexion passive, la réalisation des composants 600 peut être omise.

La figure 7 est une vue en coupe, schématique et partielle, illustrant encore une autre étape du mode de mise en œuvre du procédé de fabrication du système 100 de la figure 1, réalisée à partir de la structure telle que décrite en relation avec la figure 6.

Au cours de cette étape, on réalise un ou plusieurs trous 700 du côté de la face supérieure 500T du substrat 500. Les trous 700 s'étendent verticalement, depuis la face 500T, en direction de la face inférieure 500B du substrat 500. Dans l'exemple représenté, les trous 700 sont non traversants, c'est-à-dire qu'ils ne débouchent pas du côté de la face inférieure 500B du substrat 500. Dans cet exemple, les trous 700 traversent intégralement les couches 506 et 504 et pénètrent partiellement dans l'épaisseur de la couche 502 support. Les trous 700 sont destinés à former ultérieurement, à l'issue d'une étape d'amincissement décrite ci-après, des vias traversants (Through-Silicon Via - TSV) 118 entre les faces supérieure et inférieure du substrat 500.

À titre d'exemple, les trous 700 présentent, vus de dessus, une section circulaire. Chaque trou 700 présente, par exemple, une profondeur comprise entre 50 µm et 200 µm, par exemple de l'ordre de 100 µm. L'axe de chaque trou 700 est, par exemple, séparé de l'axe des trous 700 voisins par une distance, également appelée pas (pitch), comprise entre 20 µm et 60 µm, par exemple égale à environ 40 µm. Chaque trou 700 présente par exemple un diamètre compris entre 8 µm et 15 µm, par exemple égal à 10 µm.

La figure 8 est une vue en coupe, schématique et partielle, illustrant encore une autre étape du mode de mise en œuvre du procédé de fabrication du système 100 de la figure 1, réalisée à partir de la structure telle que décrite en relation avec la figure 7.

Au cours de cette étape, les parois internes des trous 700, autrement dit les parois latérales et le fond des trous 700, sont intégralement revêtues d'une couche 800 en un matériau isolant électriquement, par exemple de l'oxyde de silicium. La couche 800 est, par exemple, obtenue par un procédé de dépôt chimique en phase vapeur (Chemical Vapor Deposition - CVD). L'épaisseur de la couche 800 recouvrant les parois internes de chaque trou 700 est ajustée de telle sorte que la couche 800 ne comble pas totalement le trou 700. À titre d'exemple, l'épaisseur de la couche 800 est comprise entre 300 nm et 400 nm, par exemple égale à 350 nm.

Les trous 700 sont ensuite comblés par un matériau 802 conducteur électriquement, de préférence un métal ou un alliage métallique, par exemple du cuivre. En pratique, la métallisation 802 de chaque trou 700 est par exemple réalisée par une électrolyse de cuivre, ou de tout autre matériau métallique conducteur, par exemple grâce à une couche d'accroche conductrice (non représentée) préalablement déposée sur les flancs du trou 700. À titre d'exemple, la couche d'accroche se compose de titane et de nitrure de titane et est obtenue par dépôt physique en phase vapeur (Physical Vapor Deposition - PVD, en anglais). À l'issue de cette opération de remplissage des trous 700, le matériau 802 affleure ou dépasse la face supérieure 500T du substrat 500.

Des opérations de recuit puis de polissage mécano-chimique (Chemical Mechanical Polishing - CMP) peuvent ensuite être mises en œuvre. L'opération de polissage permet d'obtenir, du côté de la face 500T, une surface sensiblement plane.

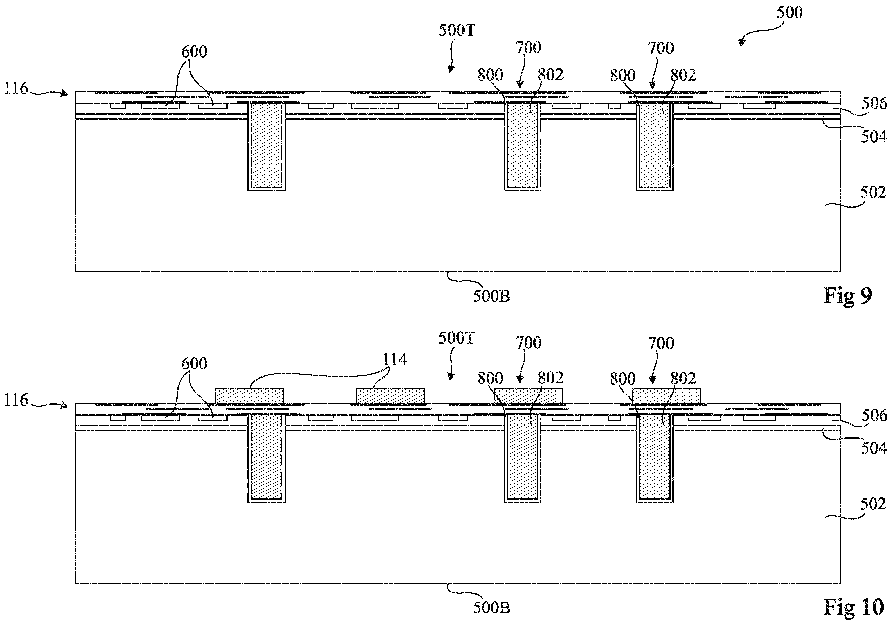

La figure 9 est une vue en coupe, schématique et partielle, illustrant encore une autre étape du mode de mise en œuvre du procédé de fabrication du système 100 de la figure 1, réalisée à partir de la structure telle que décrite en relation avec la figure 8.

Au cours de cette étape, on réalise, du côté de la face supérieure 500T du substrat 500, l'empilement 116 tel que décrit en relation avec la figure 4. Les différentes couches de l'empilement 116 sont, par exemple, obtenues par la mise en œuvre d'un procédé du type damascène.

La figure 10 est une vue en coupe, schématique et partielle, illustrant encore une autre étape du mode de mise en œuvre du procédé de fabrication du système 100 de la figure 1, réalisée à partir de la structure telle que décrite en relation avec la figure 9.

Au cours de cette étape, on réalise, du côté de la face supérieure 500T du substrat 500, les plots 114 de connexion précédemment décrits en relation avec les figures 2 et 4. Les plots 114 de connexion sont, par exemple, en le même matériau que le matériau 802 précédemment utilisé pour remplir les trous 700.

Selon un mode de mise en œuvre, la distance centre à centre entre deux plots 114 de connexion voisins, également appelée pas (pitch), est comprise entre 20 µm et 60 µm, par exemple égale à environ 40 µm.

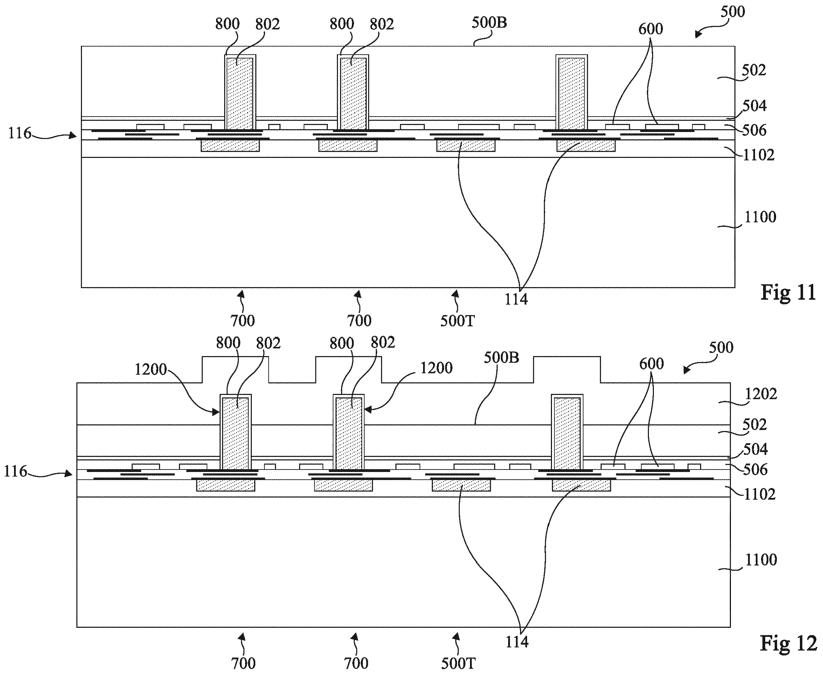

La figure 11 est une vue en coupe, schématique et partielle, illustrant encore une autre étape du mode de mise en œuvre du procédé de fabrication du système 100 de la figure 1, réalisée à partir de la structure telle que décrite en relation avec la figure 10. En figure 11, l'orientation du substrat 500 est inversée par rapport à la figure 10.

Au cours de cette étape, le substrat 500 est retourné puis collé, du côté de sa face supérieure 500T (orientée vers le bas en figure 11), sur un support ou poignée 1100. La poignée 1100 est, par exemple, une plaquette en verre ou en un matériau semiconducteur.

Le collage peut être assuré par une couche 1102 en un matériau adhésif, par exemple de la résine organique, déposée entre la face supérieure de la poignée 1100 et la face supérieure 500T du substrat 500. Dans l'exemple représenté, la couche 1102 de colle recouvre totalement les zones libres de la face supérieure (dans l'orientation de la figure 10) de l'empilement 116 et enrobe les plots 114 de connexion sur toutes leurs faces libres.

Le substrat 500 est ensuite aminci, du côté de sa face inférieure 500B (orientée vers le haut en figure 11). À titre d'exemple, on amincit le substrat 500, par exemple par meulage, jusqu'à ce qu'il présente une épaisseur comprise entre 30 µm et 300 µm, de préférence entre 50 µm et 150 µm. Dans l'exemple représenté, l'amincissement est interrompu avant d'atteindre le fond des trous 700.

La figure 12 est une vue en coupe, schématique et partielle, illustrant encore une autre étape du mode de mise en œuvre du procédé de fabrication du système 100 de la figure 1, réalisée à partir de la structure telle que décrite en relation avec la figure 11.

Au cours de cette étape, on commence par mettre à nu les portions de couche 800 situées au fond de chaque trou 700. Pour cela, on effectue par exemple une gravure d'une partie de l'épaisseur de la couche 502 à partir de la face 500B. Dans cet exemple, la gravure est une gravure sélective par rapport au matériau de la couche 800. Dans l'exemple représenté, à l'issue de la gravure, des portions 1200 de couche 800 et de matériau 802, situées au fond des trous 700, sont en saillie de la face 500B de la couche 502.

La face supérieure (dans l'orientation de la figure 12) de la structure ainsi obtenue est ensuite revêtue d'une couche isolante 1202. La couche 1202 s'étend de façon continue sur toute la surface de la structure. Dans l'exemple représenté, la couche 1202 présente une épaisseur supérieure à la hauteur des portions 1200 en saillie de la face 500B de la couche 502. La couche 1202 entoure ainsi les portions 1200 sur toutes leurs faces libres.

La couche 1202 peut être formée par une technique différente de celle mise en œuvre pour réaliser l'empilement 116. Selon un mode de mise en œuvre, la couche 1202 est en un oxyde d'un matériau semiconducteur, par exemple en oxyde de silicium, formé à une température comprise entre 150 °C et 230 °C, par exemple égale à environ 180 °C. On parle dans ce cas de couche 1202 d'oxyde « basse température ».

À titre d'exemple, une couche en un matériau isolant électriquement, par exemple en nitrure de silicium, peut être ajoutée du côté de la face inférieure 102B de la puce 102. Une telle couche, intercalée par exemple entre la couche 502 et la couche 1202, permet notamment d'ajuster la compensation de contrainte à une température donnée, par exemple à la température ambiante.

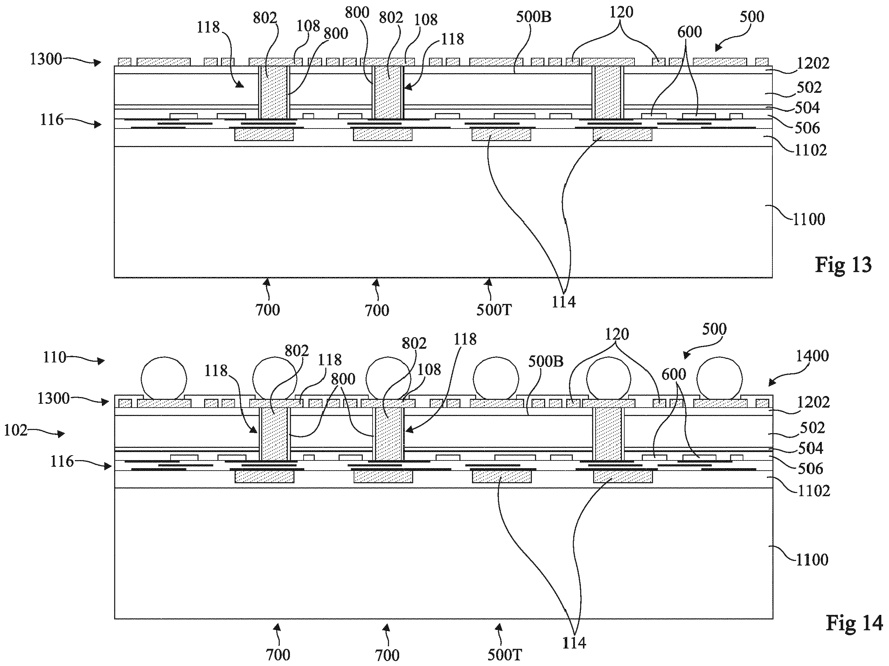

La figure 13 est une vue en coupe, schématique et partielle, illustrant encore une autre étape du mode de mise en œuvre du procédé de fabrication du système 100 de la figure 1, réalisée à partir de la structure telle que décrite en relation avec la figure 12.

Au cours de cette étape, on planarise la couche 1202 du côté de sa face supérieure afin de mettre à nu le matériau 802 de remplissage des trous 700. À titre d'exemple, on amincit la couche 1202, par exemple par CMP, jusqu'à exposer le matériau 802 de remplissage des trous 700. On achève ainsi la réalisation des vias 118. À l'issue de cette étape, une partie de l'épaisseur de la couche isolante 1202 subsiste sur toute la surface supérieure de la structure excepté aux emplacements des vias 118.

On réalise ensuite, dans un même niveau métallique 1300, les plots 108 de connexion et les régions 120. À titre d'exemple, les plots 108 et les régions 120 peuvent être réalisés par un procédé dit « semi-additif », comprenant par exemple une étape de dépôt électrolytique entre des portions d'une couche de résine (non représentée). À titre d'exemple, le dépôt électrolytique présente une épaisseur comprise entre 0,5 µm et 10 µm, par exemple inférieure à 7 µm, de préférence comprise entre 3 µm et 5 µm. L'épaisseur de ce dépôt, qui conditionne l'épaisseur des plots 108 et des régions 120, permet notamment d'ajuster la compensation des contraintes mécaniques s'exerçant du côté de la face 102T de la puce 102 (figure 1).

La figure 14 est une vue en coupe, schématique et partielle, illustrant encore une autre étape du mode de mise en œuvre du procédé de fabrication du système 100 de la figure 1, réalisée à partir de la structure telle que décrite en relation avec la figure 13.

Au cours de cette étape, on dépose une couche de passivation 1400 du côté de la face 500B. Dans l'exemple représenté, la couche 1400 présente une épaisseur supérieure aux plots 108 de connexion et aux régions 120. La couche 1400 enrobe notamment toutes les faces libres des plots 108 et des régions 120. La couche 1400 est en un matériau isolant, par exemple une résine organique.

On pratique ensuite des ouvertures dans la couche 1400 afin d'exposer au moins une partie de la surface supérieure de chaque plot 108 de connexion.

On réalise ensuite la matrice 110 de billes de soudure. Les billes de soudure de la matrice 110 présentent par exemple chacune un diamètre compris entre 40 µm et 500 µm. Dans l'exemple représenté, une bille de soudure est placée sur chaque plot 108 de connexion.

Préalablement à la réalisation de la matrice 110, des métallisations d'interface (non représentées) peuvent éventuellement être réalisées sur les plots 108, par exemple des métallisations de type UBM (de l'anglais Under-Bump Metallization) constituées chacune d'un empilement de plusieurs couches métalliques de métaux distincts.

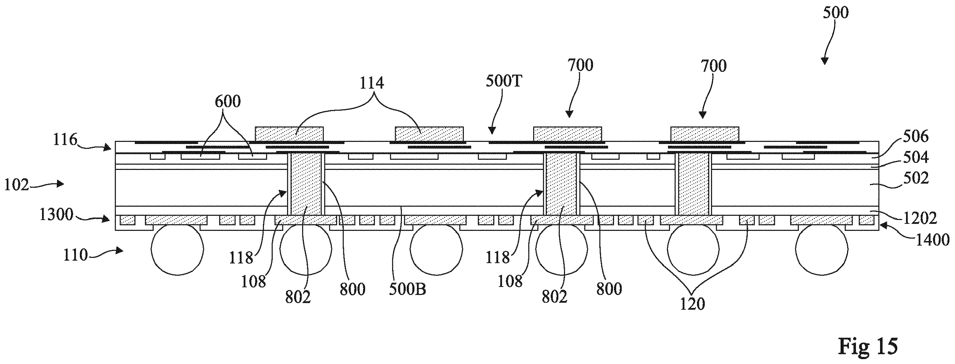

La figure 15 est une vue en coupe, schématique et partielle, illustrant encore une autre étape du mode de mise en œuvre du procédé de fabrication du système 100 de la figure 1, réalisée à partir de la structure telle que décrite en relation avec la figure 14. En figure 15, l'orientation du substrat 500 est inversée par rapport à la figure 14.

Au cours de cette étape, on sépare la puce 102 de la poignée 1100 (figure 14). À titre d'exemple, la puce 102 est désolidarisée de la poignée 1100 par une opération de chauffage.

Des étapes (non représentées) de report de la puce 102 d'interconnexion sur la carte 104 de circuit imprimé puis de report de la puce 106 de circuit intégré sur la puce 102 peuvent ensuite être réalisées pour obtenir le système 100 précédemment décrit.

Un avantage du mode de mise en œuvre du procédé de fabrication de la puce 102 d'interconnexion exposé en relation avec les figures 5 à 15 réside dans le fait que la réalisation des régions 120 ne nécessite pas d'étape supplémentaire par rapport à un procédé de fabrication d'une puce ne comprenant, du côté de sa face inférieure 102B, que les plots 108 de connexion. Les régions 120 et les plots 108 sont, en effet, simultanément formés au cours d'une même étape.

On a décrit ci-dessus en relation avec les figures 5 à 15 un mode de mise en œuvre d'un procédé de fabrication d'une puce 102 d'interconnexion dans lequel les trous 700 des vias 118 conducteurs sont réalisés après l'étape de fabrication des composants 600 et avant l'étape d'amincissement de la portion 502 du substrat 500. À titre de variante, les trous 700 peuvent être réalisés à d'autres étapes du procédé, en particulier avant la fabrication des composants 600 ou après l'étape d'amincissement de la portion 502 du substrat 500.

En outre, bien que l'on ait décrit en relation avec les figures 5 à 15 un mode de mise en œuvre dans lequel le substrat 500 présente une structure du type SOI, la personne du métier est capable d'adapter le mode de mise en œuvre décrit à d'autres types de substrats, en particulier à des substrats semiconducteurs massifs, par exemple en silicium.

Divers modes de réalisation, modes de mise en œuvre et variantes ont été décrits. La personne du métier comprendra que certaines caractéristiques de ces divers modes de réalisation, modes de mise en œuvre et variantes pourraient être combinées, et d'autres variantes apparaîtront à la personne du métier. En particulier, l'adaptation des modes de réalisation et modes de mise en œuvre décrits à des cas où la puce 102 d'interconnexion est destinée à recevoir plusieurs puces 106 du côté de sa surface supérieure 102T est à la portée de la personne du métier à partir des indications ci-dessus.

En outre, ce qui est exposé ci-dessus en relation avec un exemple d'application dans lequel la puce d'interconnexion 102 est interposée entre une carte 104 de circuit imprimé et une puce 106 de circuit intégré s'applique plus généralement à tout type d'application dans lequel une puce d'interconnexion est interposée entre au moins deux dispositifs électroniques. En particulier, l'adaptation des modes de réalisation et modes de mise en œuvre décrits à un cas où la puce d'interconnexion 102 est interposée entre des puces de circuit intégré analogues à la puce 106 est à la portée de la personne du métier à partir des indications ci-dessus.

Par ailleurs, les modes de réalisation décrits ne se limitent pas aux exemples de dimensions et de matériaux mentionnés dans la présente description.

Enfin, la mise en œuvre pratique des modes de réalisation, modes de mise en œuvre et variantes décrits est à la portée de la personne du métier à partir des indications fonctionnelles données ci-dessus. En particulier, l'évaluation de la densité de régions 120 et de l'épaisseur des régions 120 à prévoir du côté de la face inférieure 102B de la puce 102 d'interconnexion, pour réduire ou palier la déformation susceptible d'être induite par les couches métalliques de l'empilement 116, est à la portée de la personne du métier. À titre d'exemple, les valeurs de densité et d'épaisseur des régions 120 forment un jeu de paramètres susceptible d'être optimisé par la personne du métier pour différentes filières technologiques génériques de réalisation, ou nœuds technologiques, de la puce 102 d'interconnexion.

## Revendications

1. Puce (102) d'interconnexion formée dans et sur un substrat (500) semiconducteur, destinée à être interposée entre un premier dispositif (104) électronique et un deuxième dispositif (106) électronique, la puce comportant une première face (102B), destinée à être placée en regard du premier dispositif électronique, et une deuxième face (102T), opposée à la première face et destinée à être placée en regard du deuxième dispositif, la puce comportant en outre, du côté de la première face :
au moins un plot (108) métallique assurant une fonction de connexion électrique avec le premier dispositif électronique ; et
au moins une région (120) métallique dépourvue de fonction de connexion électrique,
dans laquelle ledit au moins un plot et ladite au moins une région font partie d'un même niveau (1300) métallique de routage et dans laquelle ledit au moins un plot est relié à la deuxième face de la puce d'interconnexion par l'intermédiaire d'un via conducteur, traversant le substrat semiconducteur.

2. Puce (102) selon la revendication 1, dans laquelle ladite au moins une région (120) métallique est entièrement entourée de matériau isolant.

3. Puce (102) selon la revendication 1 ou 2, comportant, du côté de la deuxième face (102T), un empilement (116) de couches métalliques et isolantes alternées, formant un réseau d'interconnexion.

4. Puce (102) selon l'une quelconque des revendications 1 à 3, comportant une pluralité de régions (120) métalliques réparties de façon régulière dans au moins une région de la première face (102B) ne comportant aucun plot (108) métallique.

5. Puce (102) selon la revendication 4, dans laquelle les régions (120) métalliques forment, dans ladite au moins une région de la première face (102B) ne comportant aucun plot (108) métallique, un réseau dont le pas est supérieur à environ 10 µm, de préférence compris entre 10 µm et 500 µm, plus préférentiellement compris entre 50 µm et 200 µm.

6. Puce (102) selon la revendication 4 ou 5, dans laquelle les régions (120) métalliques occupent entre 10 % et 50 %, de préférence entre 30 % et 50 %, de la surface de ladite au moins une région de la première face (102B) ne comportant aucun plot (108) métallique.

7. Puce (102) selon l'une quelconque des revendications 1 à 6, dans laquelle chaque région (120) métallique présente, vue de côté, une épaisseur comprise entre 0,5 µm et 10 µm, de préférence comprise entre 3 µm et 5 µm.

8. Puce (102) selon l'une quelconque des revendications 1 à 7, dans laquelle chaque région (120) métallique présente une forme de plot présentant de préférence, vu de face, une dimension maximale comprise entre 20 µm et 100 µm, de préférence égale à environ 50 µm.

9. Puce (102) selon l'une quelconque des revendications 1 à 7, dans laquelle chaque région (120) métallique présente une forme de bande présentant de préférence, vue de face, une largeur comprise entre 20 µm et 100 µm, de préférence égale à environ 50 µm.

10. Puce (102) selon l'une quelconque des revendications 1 à 9, dans laquelle le substrat (500) semiconducteur présente une épaisseur comprise entre 30 µm et 300 µm, de préférence entre 50 µm et 150 µm.

11. Puce (102) selon l'une quelconque des revendications 1 à 10, dans laquelle les première et deuxième faces (102B, 102T) présentent chacune une surface comprise entre 1 cm² et 15 cm².

12. Puce (102) selon l'une quelconque des revendications 1 à 11, comprenant en outre des composants (600) électroniques et/ou photoniques réalisés dans une couche semiconductrice (506) du substrat (500).

13. Système (100) comprenant :
un premier dispositif (104) électronique ;
une puce (102) d'interconnexion selon l'une quelconque des revendications 1 à 12, connectée, par sa première face (102B), à une face supérieure (104T) du premier dispositif électronique ; et
un deuxième dispositif (106) électronique, dont une face inférieure (106B) est connectée à la face supérieure (102T) de la puce (102) d'interconnexion.

14. Système (100) selon la revendication 13, dans lequel :
le premier dispositif (104) électronique est une carte de circuit imprimé ; et
le deuxième dispositif (106) électronique est une puce de circuit intégré.

15. Procédé de fabrication d'une puce (102) d'interconnexion selon l'une quelconque des revendications 1 à 12, dans lequel ledit au moins un plot (108) métallique et ladite au moins une région (120) métallique sont formés simultanément au cours d'une même étape.
